(19) **Europäisches Patentamt European Patent Office Office européen des brevets**

(11) **EP 3 459 177 B1**

(12) **FASCICULE DE BREVET EUROPEEN**

(45) Date de publication et mention de la délivrance du brevet:
**27.10.2021 Bulletin 2021/43**

(51) Int Cl.:
*H03K 9/06* (2006.01)          *G01S 7/02* (2006.01)

(21) Numéro de dépôt: **17726888.5**

(22) Date de dépôt: **19.05.2017**

(86) Numéro de dépôt international:
**PCT/EP2017/062185**

(87) Numéro de publication internationale:
**WO 2017/198860 (23.11.2017 Gazette 2017/47)**

(54) **PROCÉDÉ DE TRAITEMENT D'UN SIGNAL FORMÉ D'UNE SÉQUENCE D'IMPULSIONS**

VERFAHREN ZUM BEARBEITEN EINES AUS PULSSEQUENZEN GEFORMTEN SIGNALES

METHOD TO MANIPULATE A PULS SEQUENCE SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.05.2016 FR 1600815**

(43) Date de publication de la demande:
**27.03.2019 Bulletin 2019/13**

(73) Titulaire: **Thales**
**92400 Courbevoie (FR)**

(72) Inventeurs:
• **GRANDIN, Jean-François**
**78851 Elancourt Cedex (FR)**
• **LEMOINE, Jean-Marie**
**78851 Elancourt Cedex (FR)**
• **COIGNET, Eric**
**78851 Elancourt Cedex (FR)**

(74) Mandataire: **Lavoix**
**2, place d'Estienne d'Orves**
**75441 Paris Cedex 09 (FR)**

(56) Documents cités:
**EP-A1- 2 309 289     US-A- 5 396 250**

• **MARDIA H K: "NEW TECHNIQUES FOR THE DEINTERLEAVING OF REPETITIVE SEQUENCES", IEE PROCEEDINGS F. COMMUNICATIONS, RADAR & SIGNALPROCESSING, INSTITUTION OF ELECTRICAL ENGINEERS. STEVENAGE, GB, vol. 136, no. 4, PART F, 1 août 1989 (1989-08-01), pages 149-154, XP000052595, ISSN: 0956-375X cité dans la demande**

**Description**

La présente invention concerne un procédé de traitement d'un signal formé d'une séquence d'impulsions, comportant au moins un motif répétitif formé d'au moins une impulsion, ledit motif étant répété dans le signal avec une période de répétition de motif.

L'invention se situe dans le domaine du traitement des signaux, en particulier des signaux numériques, et trouve une application particulière dans le domaine de la caractérisation de séquences d'impulsions radar.

En effet, un signal périodique ou cyclo-périodique, formé de motifs d'impulsions qui se répètent, est en général caractérisé par des paramètres dont la période de répétition de motif, ou PRM, et les intervalles de répétition des impulsions, ou PRI du signal. En pratique, la caractérisation d'un signal radar intercepté dans un créneau temporel d'écoute permet notamment d'identifier le mode d'émission du signal intercepté ou de pister des séquences d'impulsions provenant d'une même émission.

De manière connue, les intervalles de répétition des impulsions sont utilisés pour caractériser une telle séquence d'impulsions.

Le document EP 2 309 289 A1 décrit un mode de réalisation dans lequel la séparation des trains d'impulsions se fait en analysant la phase des impulsions, la phase étant définie comme étant égale à la date d'arrivée module la phase de répétition d'impulsion.

Document US 5 396 250 décrit un processeur d'intervalle de répétition d'impulsions pour l'estimation spectrale des périodicités radar qui utilise la transformée de Fourier discrète pour extraire les propriétés périodiques des signaux radar dont l'heure d'arrivée sur la plate-forme aéroportée a été marquée par le récepteur.

Cependant, les valeurs de PRI sont faussées en cas de perte aléatoire d'impulsions du signal, phénomène également connu sous le nom de mitage, qui se produit en pratique.

L'invention vise à améliorer la caractérisation des périodes de répétition temporelle des impulsions dans une séquence d'impulsions, notamment dans le cas de pertes aléatoires.

A cet effet, selon un premier aspect, l'invention propose, un procédé de traitement d'un signal formé d'une séquence d'impulsions, comportant au moins un motif répétitif formé d'au moins une impulsion, ledit motif étant répété dans le signal avec une période de répétition de motif. Le procédé comporte les étapes suivantes :

- estimation de la période de répétition de motif dudit signal,
- calcul d'une séquence de phases en fonction d'une date d'arrivée de chaque impulsion par rapport à une date d'arrivée de référence choisie et de la période de répétition de motif estimée,
- à partir de ladite séquence de phases calculées, estimation d'au moins une valeur de phase et d'un écart-type associé, ladite valeur de phase étant associée à un moment de phase représentatif du motif répétitif ;
- obtention et exploitation de paramètres de caractérisation du signal en utilisant les valeurs de phase estimées.

Avantageusement, le procédé de l'invention permet de caractériser les répétitions temporelles caractéristiques d'une séquence d'impulsions de manière robuste aux pertes aléatoires d'impulsions.

Le procédé proposé s'applique pour les séquences d'impulsions à trains d'impulsions imbriqués ou successifs, la période de répétition des impulsions d'un train d'impulsions pouvant être ou non affectée d'un bruit aléatoire ou pseudo-aléatoire induisant une fluctuation de la période de répétition par rapport à une valeur moyenne.

Le procédé selon l'invention peut présenter une ou plusieurs des caractéristiques ci-dessous, prises indépendamment ou dans toutes leurs combinaisons techniquement acceptables.

Il comprend, après l'étape de calcul d'une séquence de phases, une étape de construction d'un histogramme de phases, et d'extraction d'un ou plusieurs pic(s) de l'histogramme, chaque pic étant associé à un moment de phase de la séquence d'impulsions.

L'étape d'estimation d'une phase associée à un moment de la séquence d'impulsions, ledit moment étant associé à un pic de l'histogramme de phases, comprend une extraction d'un sous-ensemble de dates d'arrivée autour dudit pic, et une estimation précise de la valeur de phase associée audit moment, et d'une variance associée à la valeur de phase estimée.

Lorsque la séquence d'impulsions comprend une pluralité de trains d'impulsions imbriqués, chaque train d'impulsions ayant un moment de phase associé, l'estimation précise de la phase associée au moment comprend une sommation vectorielle de vecteurs unités, chaque vecteur ayant une orientation égale à une valeur de phase calculée, avec la période de répétition de motif dudit signal préalablement estimée, à partir d'une date d'arrivée dudit sous-ensemble, ladite sommation vectorielle fournissant un vecteur résultant.

La valeur de phase associée audit moment estimée est égale à l'argument dudit vecteur résultant.

Lorsque la séquence d'impulsions comprend une pluralité de trains d'impulsions successifs, chaque train d'impulsions ayant un moment de phase associé, l'estimation précise de la phase associée à un moment traité comprend en outre une estimation d'une période de répétition de motifs correspondant audit moment à partir du sous-ensemble de dates d'arrivée considérées.

L'estimation de la période de répétition de motif du signal comporte une première estimation grossière d'une première valeur estimée de la période de répétition de motif, et une deuxième estimation raffinée d'une deuxième valeur estimée de la période de répétition de motif.

Lors de l'étape d'obtention d'une séquence de phases, pour chaque date d'arrivée d'impulsion $t_n$, on applique un repliement de période égale à la période de répétition de motif estimée selon la formule suivante :

$$\phi(t_n)_{\lambda, t_0} = \lambda \cdot \left( \frac{t_n - t_0}{\lambda} - \left\lfloor \frac{t_n - t_0}{\lambda} \right\rfloor \right)$$

Où $\lfloor x \rfloor$ est la partie entière inférieure du nombre réel x, $t_0$ est la date d'arrivée de référence et $\lambda$ la période de répétition de motif estimée.

Selon un autre aspect, l'invention concerne un dispositif de traitement d'un signal formé d'une séquence d'impulsions successives, apte à mettre en œuvre un procédé tel que brièvement décrit ci-dessus.

Ce dispositif comporte au moins un processeur de calcul apte à mettre en oeuvre :

- une unité d'estimation de la période de répétition de motif dudit signal,
- une unité de calcul, en fonction d'une date d'arrivée de chaque impulsion par rapport à une date d'arrivée de référence choisie, et de la période de répétition de motif estimée, d'une séquence de phases,
- une unité d'estimation, à partir de ladite séquence de phases calculées, d'au moins une valeur de phase et d'un écart-type associé, ladite valeur de phase étant associée à un moment de phase représentatif du motif répétitif ;
- une unité d'obtention et d'exploitation de paramètres de caractérisation du signal numérique en utilisant les valeurs de phase estimées.

Selon un mode de réalisation le dispositif comprend en outre une unité de construction d'un histogramme de phases, et d'extraction d'un ou plusieurs pic(s) de l'histogramme, chaque pic étant associé à un moment de phase de la séquence d'impulsions.

Selon un autre mode de réalisation, l'invention concerne un programme d'ordinateur comportant des instructions logicielles qui, lorsqu'elles sont mises en œuvre par un dispositif programmable, mettent en œuvre un procédé de traitement d'un signal formé d'une séquence d'impulsions tel que brièvement décrit ci-dessus.

Selon un autre aspect, l'invention concerne un support d'enregistrement d'informations, comportant des instructions logicielles pour l'exécution d'un procédé de traitement d'un signal formé d'une séquence d'impulsions tel que brièvement décrit ci-dessus, lorsque ces instructions sont exécutées par un dispositif programmable.

D'autres caractéristiques et avantages de l'invention ressortiront de la description qui en est donnée ci-dessous, à titre indicatif et nullement limitatif, en référence aux figures annexées, parmi lesquelles :

- la figure 1 est une vue schématique d'une séquence d'impulsions à trains d'impulsions imbriqués ;
- la figure 2 est un schéma synoptique des principales étapes d'un procédé selon un mode de réalisation de l'invention ;
- la figure 3 illustre schématiquement plusieurs périodes de répétition d'un signal numérique et un histogramme de phases associé ;
- la figure 4 est un schéma représentant les blocs fonctionnels d'un dispositif programmable apte à mettre en œuvre l'invention.

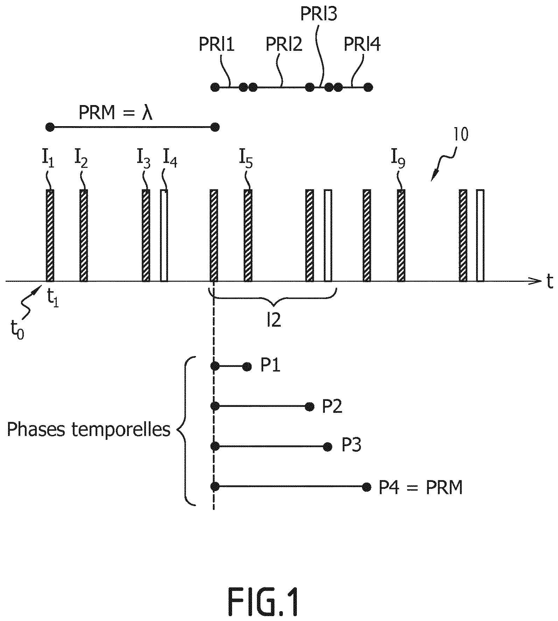

La figure 1 illustre schématiquement un signal numérique S comportant une séquence d'impulsions 10, composée d'impulsions $I_1$, $I_2$, ...$I_n$ reçues successivement dans le temps. Chaque impulsion $I_k$ est illustrée schématiquement sur un axe temporel.

La séquence d'impulsions 10 est une séquence à répétition de motif, et comprend, dans l'exemple simplifié illustré, quatre trains binaires périodiques imbriqués.

Bien entendu, dans la pratique, des signaux numériques réels traités comprennent un nombre P quelconque de signaux imbriqués.

Dans l'exemple de la figure 1, le motif 12 est composé de quatre impulsions successives, $I_1$ à $I_4$, et de période de répétition de motif $\lambda$.

Les différences entre dates d'arrivée sur l'axe temporel, connues sous l'abréviation DTOA (« différence of time of arrivai ») entre deux impulsions successives permettent de calculer les valeurs d'intervalle entre impulsions successives, notés respectivement $PRI_1$ à $PRI_4$.

Chacun des trains d'impulsions imbriqués dans la séquence d'impulsions 10 est constitué d'impulsions se répétant avec une période de répétition λ, égale à la période de répétition de motif de la séquence d'impulsions 10.

En d'autres termes, chaque train d'impulsions $T_p$ est constitué des impulsions $\{I_{k \cdot \lambda + p}\}$.

La date d'arrivée de référence $t_0$ est choisie arbitrairement, par exemple égale à la date d'arrivée de la première impulsion de la séquence d'impulsions considérée.

La perte aléatoire d'une sous-partie des impulsions induit une erreur sur le calcul des valeurs de $PRI_k$ d'une séquence d'impulsions reçue.

Il est proposé de calculer des valeurs de phase pour chaque impulsion, représentatives de la différence $P_i$, pour chaque impulsion, entre sa date d'arrivée et une date de référence périodisée par rapport à la période de répétition de motif. En particulier, $P_1$ à $P_4$ sont illustrées sur la figure 1 pour l'exemple considéré.

Les valeurs de phase sont calculées comme suit.

A partir d'une séquence de dates d'arrivée $\{t_k\}$, on calcule des phases, avec un repliement de période λ donnée, par rapport à une date d'arrivée de référence $t_0$ par la formule suivante :

$$\theta_k = \phi(t_k)_{\lambda, t_0} = \lambda \cdot \left( \frac{t_k - t_0}{\lambda} - \left\lfloor \frac{t_k - t_0}{\lambda} \right\rfloor \right) \quad \text{(EQ 1)}$$

Où $\lfloor x \rfloor$ est la partie entière inférieure (ou par défaut) du nombre réel x.

Les valeurs de phase $\theta_k$ sont supérieures ou égales à 0 et strictement inférieures à λ.

Les valeurs de phase ainsi calculées ont une meilleure robustesse aux pertes aléatoires d'impulsions que les valeurs DTOA mesurées entre impulsions successives, lorsque les valeurs respectives de date d'arrivée de référence $t_0$ et de période λ sont connues ou préalablement déterminées.

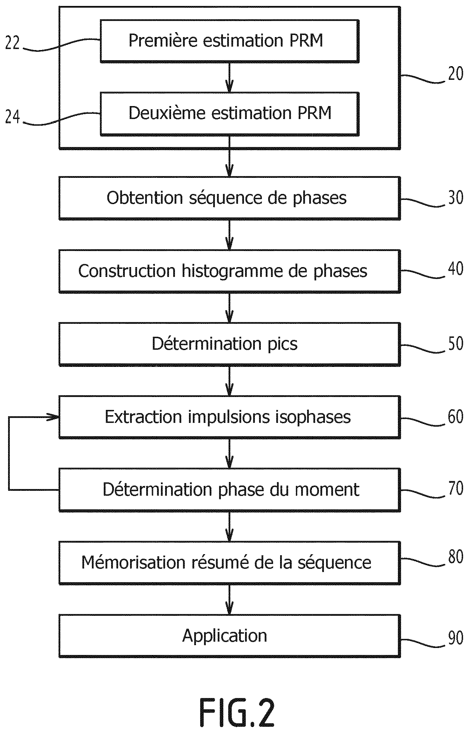

Les principales étapes d'un mode de réalisation du procédé de traitement de signal selon l'invention seront décrites ci-après en référence à la figure 2.

Ce procédé s'applique dans le cas d'une séquence d'impulsions formée d'une pluralité de P trains d'impulsions imbriqués, avec P un entier supérieur à 1, chaque train d'impulsions formant un moment de phase m(i) de la séquence d'impulsions. Une telle séquence d'impulsions est également appelée « stagger à P moments ». Par exemple, la figure 1 illustre un signal stagger à 4 moments.

Le procédé de l'invention s'applique également au cas d'une séquence d'impulsions formée d'une pluralité de P trains d'impulsions qui se succèdent temporellement, chacun des trains d'impulsions ayant une période de répétition de motif associée, égale à la période de répétition des impulsions dudit train d'impulsions.

Il n'est pas nécessaire de connaître le type de séquence à l'avance, le procédé permet de le déduire.

Dans un cas d'application, la séquence d'impulsions est en plus affectée, volontairement à sa création par le concepteur du radar, par un bruit appelé jitter en anglais, la période de répétition des impulsions fluctuant de manière aléatoire ou pseudo-aléatoire autour d'une valeur moyenne.

Chaque moment m(i) a une valeur de phase associée, les impulsions du train d'impulsion $T_i$ associé à m(i) ayant une période de répétition λ, qui est la même que la période de répétition associée à la séquence d'impulsions.

Dans le mode de réalisation décrit, on dispose des dates d'arrivée : $\{t_k, 1 \le k \le n\}$ des impulsions d'une séquence d'impulsions à traiter, dans un référentiel temporel donné. Ces dates d'arrivée sont par exemple mémorisées dans une mémoire d'un dispositif de calcul apte à mettre en œuvre l'invention.

Lors d'une première étape 20 d'estimation de la période de répétition de motif, mise dans œuvre dans le mode de réalisation décrit, une valeur de période de répétition de motif, appelée simplement PRM, de la séquence d'impulsions, notée $\hat{\lambda}$, est calculée.

Ce calcul comprend deux sous-étapes, une première sous-étape 22 de première estimation, également appelée estimation grossière, permettant d'obtenir une première valeur estimée $\lambda_g$ de la PRM, suivie d'une deuxième sous-étape 24 de deuxième estimation, appelée également estimation fine, permettant d'obtenir une deuxième valeur estimée, $\hat{\lambda}$, de la PRM.

La première sous-étape 22 met en œuvre toute méthode connue d'estimation de la période de répétition de motif. Par exemple, des méthodes d'estimation de motif sont décrites dans le document « New techniques for the deinterleaving of repetitive sequences », de H. K. Mardia et al, publié dans IEE Proceedings F, vol 136 N°4, pp. 149-154, en août 1989. Cette estimation 22 est réalisée par exemple par les méthodes d'histogrammes des différences de dates d'arrivée (ou DTOA). En alternative, toute autre méthode d'estimation de la période de répétition de motif, utilisant une transformation de Fourier ou une transformation en ondelettes peut être utilisé. Cependant, comme dans cette première sous-étape 22 la précision de l'estimation n'est pas recherchée, il est préférable d'utiliser une méthode simple et peu coûteuse en calcul, plutôt qu'une méthode basée sur des transformations qui ont un coût calculatoire important.

Lors de la sous-étape 24 de deuxième estimation de la PRM, on calcule, pour chaque date d'arrivée mémorisée, un indice entier associé en fonction de la première valeur estimée $\lambda_g$ de la PRM :

$$k(i) = \left\lfloor \frac{t_i}{\lambda_g} \right\rfloor, \quad i = 1,\ldots,n \qquad \text{(EQ 2)}$$

Ensuite on effectue le calcul suivant :

$$\hat{\lambda} = \sum_{i=1}^{n} \left( \frac{6 \cdot (2 \cdot k(i) - k(n) - 1)}{k(n) \cdot (k(n)^2 - 1)} t_i \right) \qquad \text{(EQ 3)}$$

La variance associée à cette estimation est donnée par :

$$Var(\hat{\lambda}) \approx \frac{12 \cdot \sigma^2}{n^3 - n} \qquad \text{(EQ 4)}$$

n étant le nombre d'impulsions de la séquence d'impulsions, et $\sigma$ étant l'écart-type de la mesure de temps t.

L'écart-type $\sigma$ est celui de l'instrument de mesure des dates d'arrivée. Il est connu pour chaque instrument, pour les conditions de mesures réalisées en interception.

Les calculs indiqués ci-dessus s'appliquent notamment pour une modélisation des dates d'arrivée selon un modèle linéaire en fonction des valeurs de k(i), autrement dit pour une suite d'impulsions périodique de période λ :

$$t_i = t_0 + \lambda \cdot k(i) + \varepsilon \qquad \text{(EQ 5)}$$

Les calculs ci-dessus s'appliquent pour des séquences d'impulsions à P trains imbriqués, éventuellement bruitées par un bruit non-cumulatif.

Dans le cas d'un bruitage par bruit non-cumulatif, chaque date d'arrivée peut s'écrire de la manière suivante :

$$t_i = (i-1)\lambda + \phi_{m(i)} + \nu_i \qquad \text{(EQ 6)}$$

Où $\nu_i$ est un bruit centré d'écart-type $\sigma_V$ et $\phi_{m(i)}$ la valeur phase du moment m(i).

Selon une variante, la séquence d'impulsions reçue est affectée par un bruit (jitter) cumulatif :

$$t_i = \lambda + t_{i-1} + \phi + \nu_i \qquad \text{(EQ 7)}$$

Où $\nu_i$ est un bruit blanc gaussien centré d'écart-type $\sigma_V$ et $\phi$ la phase du train d'impulsions considéré de la séquence.

Dans cette variante, on applique le calcul suivant pour la deuxième estimation de la PRM :

$$\hat{\lambda} = \frac{t_n - t_1}{n - 1} \qquad \text{(EQ 8)}$$

La variance associée à cette estimation est donnée par :

$$Var(\hat{\lambda}) = \frac{\sigma^2}{n - 1} \qquad \text{(EQ 9)}$$

n étant le nombre d'impulsions de la séquence et $\sigma$ étant l'écart-type de la mesure de temps t. Cet écart-type cumule quadratiquement l'écart type de mesure du temps t et l'écart-type $\sigma_V$ de la loi de jitter.

De retour à la figure 2, l'étape 20 d'estimation de la PRM est suivie d'une étape 30 de calcul d'une séquence de phases, par calcul selon la formule (EQ1), prenant en compte la date d'arrivée de référence $t_0$ choisie et la valeur de la PRM estimée $\hat{\lambda}$ obtenue à l'étape 20.

On obtient donc une séquence de phases : $\{\theta_k, 1 \le k \le n\}$, $\theta_k \in [0, \hat{\lambda}[$

L'étape d'obtention d'une séquence de phases 30 est suivie d'une étape 40 de construction d'histogramme de phases.

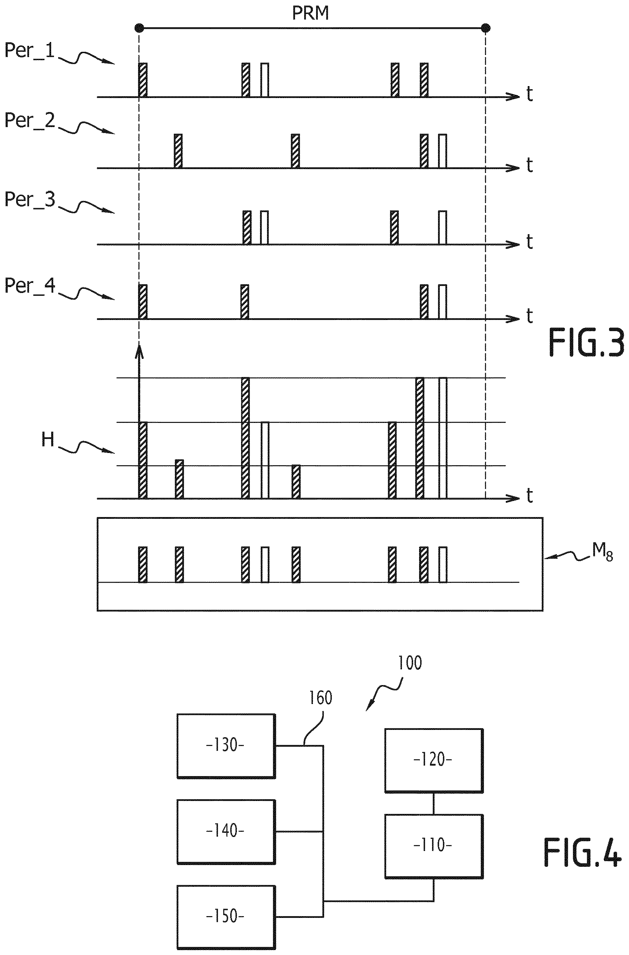

La figure 3 illustre de manière schématique une séquence d'impulsions mitée, comprenant 4 périodes successives, notées Per_1 à Per_4, superposées dans la représentation illustrée de manière à illustrer le repliement, et l'histogramme de phases H associé.

Il apparaît de cette illustration schématique que le motif $M_8$ de la séquence d'impulsions, qui est un motif dit stagger 8 dans cet exemple, est reconstituable à partir de l'histogramme de phases.

Bien entendu, il s'agit d'un exemple schématique. En pratique, les séquences d'impulsions traitées comprennent des impulsions plus rapprochées temporellement et/ou un bien plus grand nombre de trains d'impulsions imbriqués.

De retour à la figure 2, l'étape 40 de construction d'histogramme de phases est suivie d'une étape 50 de recherche de pics dans l'histogramme de phases.

On applique toute méthode connue à cet effet.

Dans un mode de réalisation, les pics retenus dans l'histogramme sont les raies de l'histogramme dont la hauteur dépasse strictement un seuil choisi. Lorsqu'il n'existe qu'un très faible nombre de raies dans l'histogramme à proportion de la taille de l'histogramme, par exemple moins de dix pour cent, le seuil choisi vaut zéro et les pics retenus sont toutes les raies de l'histogramme (ce cas correspond souvent à la présence d'un seul signal radar). A l'inverse lorsqu'il y a un grand nombre de raies (ce cas correspond souvent à la présence de plusieurs signaux radar), le seuil choisi est la moyenne des hauteurs des raies de l'histogramme, ou alpha fois cette moyenne, avec alpha supérieur ou égal à 1.

Dans une variante de traitement, les pics retenus dans l'histogramme sont des groupes de raies voisines de l'histogramme dont la hauteur dépasse le seuil calculé comme précédemment et entourant un maximum local de hauteur dans l'histogramme.

Chaque pic d'histogramme correspond à une valeur de phase d'un moment de la séquence d'impulsions.

L'étape 50 est suivie des étapes 60 et 70 d'estimation de la valeur de phase pour chaque moment de phase, qui sont itérées pour chaque pic trouvé à l'étape 50.

Pour un moment courant m(p) traité, on effectue une extraction (étape 60) des impulsions isophases, c'est-à-dire des impulsions dont la phase calculée est proche de la phase associée au moment courant m(p). En effet, en pratique, à cause de la quantification du temps mesuré, les valeurs de phases calculées sont susceptibles d'être légèrement différentes pour les impulsions d'un même moment de phase sur des intervalles de répétition de motif successifs.

De plus, les valeurs de phases peuvent être affectées par un jitter, avec bruit non-cumulatif ou cumulatif.

Dans un mode de réalisation, à l'étape 60 on sélectionne les impulsions situées autour du pic d'histogramme traité, dans une fenêtre de taille déterminée par l'écart type du jitter, par exemple une taille de fenêtre proche de trois fois l'écart-type de jitter.

L'étape 60 d'extraction des impulsions isophases est suivie d'une étape 70 d'estimation précise de la valeur de phase associée au moment m(p).

Lors de l'étape 70, pour une séquence d'impulsions composée d'une pluralité P de trains d'impulsions imbriqués, on utilise la période de répétition de motif $\hat{\lambda}$, estimée à l'étape 20, pour chaque moment m(p) traité : $\hat{\lambda}_{m(p)} = \hat{\lambda}$.

Si la séquence d'impulsions initiale est formée d'une pluralité de trains d'impulsions qui se succèdent dans le temps, chaque moment m(p) étant associé à un train d'impulsions distinct, lors de l'étape 70 on effectue d'abord l'estimation précise de la période de répétition de motif $\hat{\lambda}_{m(p)}$ associée au moment m(p), ainsi que de la variance associée $\text{var}(\hat{\lambda}_{m(p)})$.

Les calculs effectués sont analogues à ceux de l'étape 24, sur l'ensemble des impulsions extraites à l'étape 60.

Ensuite, pour tout type de séquence d'impulsions, on applique les calculs suivants pour estimer la phase $\hat{\mu}_{m(p),t_0}$ associée au moment m(p), en utilisant la date d'arrivée de référence $t_0$.

Le calcul est effectué sur les impulsions sélectionnées à l'étape 60, qui sont au nombre de N(p) impulsions.

On calcule la somme vectorielle suivante, permettant d'obtenir un vecteur résultant S(p) :

$$S(p) = \sum_{k=1}^{N(p)} \exp\left(i\phi\left(t_{k,p}\right)_{\hat{\lambda}_{m(p)},t_0}\right) \qquad \text{(EQ 10)}$$

Où $t_{k,p}$ est la date d'arrivée de la kième impulsion du moment m(p), et les valeurs $\phi\left(t_{k,p}\right)_{\hat{\lambda}_{m(p)},t_0}$ sont calculées selon l'équation (EQ 1) avec la valeur de période de répétition de motif $\hat{\lambda}_{m(p)}$ estimée.

L'estimation de la phase $\hat{\mu}_{m(p),t_0}$ associée au moment m(p) est donnée par :

$$\hat{\mu}_{m(p),t_0} = \arg[S(p)] \qquad\qquad \text{(EQ 11)}$$

Où arg[S(p)] est l'argument du vecteur S(p).

La variance associée à cette estimation est donnée par :

$$\text{var}(\hat{\mu}_{m(p),t_0}) = -2\ln\left(\frac{1}{N(p)}|S(p)|\right) \qquad \text{(EQ 12)}$$

Où $|S(p)|$ est la norme de la somme vectorielle S(p) et ln(x) est le logarithme népérien de x.

De retour à la figure 2, l'étape 70 d'estimation précise de la phase du moment m(p) est suivie d'une étape 80 de caractérisation de la séquence d'impulsions initiale par l'enregistrement d'un résumé comprenant des paramètres caractéristiques de cette séquence :

- Dans le cas où la séquence d'impulsions traitée est constituée de trains d'impulsions imbriqués, le résumé comporte :

   ◦ Le nombre de moments P ;
   ◦ Les valeurs calculées de la période de répétition de motif $\hat{\lambda}$, et la variance associée ;
   ◦ Pour chaque moment, la valeur de phase estimée $\hat{\mu}_{m(p),t0}$, et la variance associée.

- Dans le cas où la séquence d'impulsions traitée est constituée de trains d'impulsion successifs, le résumé comporte :

   ◦ Le nombre de moments P,
   ◦ Pour chaque moment :

      ▪ la valeur calculée de la période de répétition de motif $\hat{\lambda}_{m(p)}$, la variance associée,
      ▪ la valeur de phase estimée $\hat{\mu}_{m(p),t0}$, et la variance associée.

Ces résumés permettant de caractériser la séquence d'impulsions traitée sont mémorisés, et sont exploitables à une étape d'exploitation 90 pour diverses applications, par exemple la comparaison avec des caractéristiques signal pré-enregistrées permettant d'identifier le mode d'émission du signal intercepté.

Bien évidemment, les résumés sont exploitables pour toute autre application de traitement sur les impulsions radar.

Le procédé de l'invention est mis en œuvre par un dispositif programmable, qui peut être soit intégré dans un dispositif de réception radar, soit indépendant et utilisé pour un traitement ultérieur.

Un dispositif programmable 100, tel qu'illustré schématiquement à la figure 4, apte à mettre en œuvre l'invention, typiquement un ordinateur, comprend une unité centrale de traitement 110, ou CPU, apte à exécuter des instructions de programme informatique lorsque le dispositif 100 est mis sous tension. Le dispositif 100 comporte également des moyens de stockage d'informations 120, par exemple des registres ou des mémoires, aptes à stocker des instructions de code exécutable permettant la mise en œuvre de programmes comportant des instructions de code aptes à mettre en œuvre les procédés selon l'invention.

Dans un mode de réalisation, les instructions logicielles pour l'exécution du procédé de traitement d'un signal formé d'une séquence d'impulsions tel que brièvement décrit ci-dessus sont stockées sur un support d'enregistrement d'informations, par exemple une mémoire externe, une mémoire de stockage de masse, un disque externe. Lorsque le support d'enregistrement d'informations est connecté au dispositif programmable, ce dispositf est apte à exécuter ces instructions logicielles, comme expliqué ci-dessus.

En option, le dispositif programmable 100 comprend un écran 130 et un moyen 140 de saisie des commandes d'un opérateur, par exemple un clavier, optionnellement un moyen supplémentaire de pointage 150, tel une souris, permettant de sélectionner des éléments graphiques affichés sur l'écran 130.

Les divers blocs fonctionnels 110 à 150 du dispositif 100 décrits ci-dessus sont connectés via un bus de communication 160.

En variante non représentée, le dispositif programmable 100 est réalisé sous forme de composants logiques programmables, tel qu'un ou plusieurs FPGA (de l'anglais *Field-Programmable Gate Array*), ou encore sous forme de circuits intégrés dédiés, de type ASIC (de l'anglais *Application-Specific Integrated Circuit*).

Avantageusement, le procédé proposé permet de traiter tout type de séquence d'impulsions, qu'il s'agisse de trains d'impulsions imbriqués ou successifs.

L'invention permet de traiter des signaux ayant plusieurs périodes de répétition de motifs, et plusieurs phases pour chaque période de répétition de motif.

Avantageusement, le procédé proposé permet d'obtenir des résumés fiables y compris dans le cas de pertes aléatoires d'impulsions, et en plus, le niveau de fiabilité de chaque estimation est quantifiable grâce à la variance d'estimation associée qui est également calculée et mémorisée.

## Revendications

1. Procédé de traitement d'un signal formé d'une séquence d'impulsions, comportant au moins un motif répétitif formé d'au moins une impulsion, ledit motif étant répété dans le signal avec une période de répétition de motif, **caractérisé en ce qu'**il comporte les étapes suivantes :

   - estimation (20) de la période de répétition de motif dudit signal,
   - calcul (30) d'une séquence de phases en fonction d'une date d'arrivée de chaque impulsion par rapport à une date d'arrivée de référence choisie et de la période de répétition de motif estimée,
   - à partir de ladite séquence de phases calculées, estimation (60, 70) d'au moins une valeur de phase et d'un écart-type associé, ladite valeur de phase étant associée à un moment de phase représentatif du motif répétitif ;
   - obtention (80) et exploitation (90) de paramètres de caractérisation du signal en utilisant les valeurs de phase estimées.

2. Procédé selon la revendication 1, comprenant, après l'étape de calcul (30) d'une séquence de phases, une étape de construction (40) d'un histogramme de phases (H), et d'extraction (50) d'un ou plusieurs pic(s) de l'histogramme (H), chaque pic étant associé à un moment de phase de la séquence d'impulsions.

3. Procédé selon la revendication 2, dans lequel l'étape d'estimation d'une phase associée à un moment de la séquence d'impulsions, ledit moment étant associé à un pic de l'histogramme de phases (H), comprend une extraction (60) d'un sous-ensemble de dates d'arrivée autour dudit pic, et une estimation précise (70) de la valeur de phase associée audit moment, et d'une variance associée à la valeur de phase estimée.

4. Procédé selon la revendication 3, dans lequel, lorsque la séquence d'impulsions comprend une pluralité de trains d'impulsions imbriqués, chaque train d'impulsions ayant un moment de phase associé, l'estimation précise (70) de la phase associée au moment comprend une sommation vectorielle de vecteurs unités, chaque vecteur ayant une orientation égale à une valeur de phase calculée, avec la période de répétition de motif dudit signal préalablement estimée, à partir d'une date d'arrivée dudit sous-ensemble, ladite sommation vectorielle fournissant un vecteur résultant.

5. Procédé selon la revendication 4, dans lequel la valeur de phase associée audit moment estimée est égale à l'argument dudit vecteur résultant.

6. Procédé selon la revendication 3, dans lequel, lorsque la séquence d'impulsions comprend une pluralité de trains d'impulsions successifs, chaque train d'impulsions ayant un moment de phase associé, l'estimation précise (70) de la phase associée à un moment traité comprend en outre une estimation d'une période de répétition de motifs correspondant audit moment à partir du sous-ensemble de dates d'arrivée considérées.

7. Procédé selon l'une quelconque des revendications 1 à 6, dans lequel l'estimation (20) de la période de répétition de motif du signal comporte une première estimation grossière (22) d'une première valeur estimée de la période de répétition de motif, et une deuxième estimation raffinée (24) d'une deuxième valeur estimée de la période de répétition de motif.

8. Procédé selon l'une quelconque des revendications 1 à 7, dans lequel lors de l'étape d'obtention (30) d'une séquence de phases, pour chaque date d'arrivée d'impulsion $t_n$, on applique un repliement de période égale à la période de répétition de motif estimée selon la formule suivante :

$$\phi(t_n)_{\lambda,t_0} = \lambda \cdot \left( \frac{t_n - t_0}{\lambda} - \left\lfloor \frac{t_n - t_0}{\lambda} \right\rfloor \right)$$

Où $\lfloor x \rfloor$ est la partie entière inférieure du nombre réel x, $t_0$ est la date d'arrivée de référence et $\lambda$ la période de répétition de motif estimée.

9. Dispositif (100) de traitement d'un signal formé d'une séquence d'impulsions, comportant au moins un motif répétitif formé d'au moins une impulsion, ledit motif étant répété dans le signal avec une période de répétition de motif, **caractérisé en ce qu'**il comporte au moins un processeur de calcul (110) apte à mettre en oeuvre :

- une unité d'estimation de la période de répétition de motif dudit signal,
- une unité de calcul, en fonction d'une date d'arrivée de chaque impulsion par rapport à une date d'arrivée de référence choisie, et de la période de répétition de motif estimée, d'une séquence de phases,
- une unité d'estimation, à partir de ladite séquence de phases calculées, d'au moins une valeur de phase et d'un écart-type associé, ladite valeur de phase étant associée à un moment de phase représentatif du motif répétitif ;
- une unité d'obtention et d'exploitation de paramètres de caractérisation du signal numérique en utilisant les valeurs de phase estimées.

10. Dispositif selon la revendication 9 comprenant en outre une unité de construction d'un histogramme de phases, et d'extraction d'un ou plusieurs pic(s) de l'histogramme, chaque pic étant associé à un moment de phase de la séquence d'impulsions.

11. Programme d'ordinateur comportant des instructions logicielles qui, lorsqu'elles sont mises en œuvre par un dispositif programmable (100), mettent en œuvre un procédé de traitement d'un signal formé d'une séquence d'impulsions conforme aux revendications 1 à 8.

**Patentansprüche**

1. Verfahren zur Verarbeitung eines Signals, das durch eine Folge von Impulsen gebildet wird, die mindestens ein sich wiederholenden Muster aufweist, das durch mindestens einen Impuls gebildet wird, wobei das Muster in dem Signal mit einer Musterwiederholungsperiode wiederholt wird, **dadurch gekennzeichnet, dass** es die folgenden Schritte umfasst:

- Schätzen (20) der Musterwiederholungsperiode des Signals,
- Berechnen (30) einer Phasenfolge abhängig von einem Ankunftsdatum jedes Impulses in Bezug zu einem gewählten Referenzankunftsdatum und der geschätzten Musterwiederholungsperiode,
- aus der berechneten Phasenfolge Schätzen (60, 70) von mindestens einem Phasenwert und einer zugeordneten Standardabweichung, wobei der Phasenwert einem für das sich wiederholende Muster repräsentativen Phasenmoment zugeordnet ist;
- Gewinnen (80) und Auswerten (90) von Parametern der Charakterisierung des Signals unter Verwendung der geschätzten Phasenwerte.

2. Verfahren nach Anspruch 1, das nach dem Schritt des Berechnens (30) einer Phasenfolge einen Schritt des Konstruierens (40) eines Phasenhistogramms (H) und des Extrahierens (50) einer oder mehrerer Spitzen aus dem Histogramm (H) umfasst, wobei jede Spitze einem Phasenmoment der Impulsfolge zugeordnet ist.

3. Verfahren nach Anspruch 2, bei dem der Schritt des Schätzens einer Phase, die einem Moment der Impulsfolge zugeordnet ist, wobei der Moment einer Spitze des Phasenhistogramms (H) zugeordnet ist, eine Extraktion (60) einer Teilmenge von Ankunftsdaten um die Spitze herum und eine genaue Schätzung (70) des Phasenwertes, der dem Moment zugeordnet ist, und einer Varianz, die dem geschätzten Phasenwert zugeordnet ist, umfasst.

4. Verfahren nach Anspruch 3, bei dem, wenn die Impulsfolge eine Mehrzahl von verschachtelten Impulsfolgen umfasst, wobei jede Impulsfolge einen zugehörigen Phasenmoment aufweist, die genaue Schätzung (70) der dem Moment zugeordneten Phase eine Vektorsummierung von Einheitsvektoren umfasst, wobei jeder Vektor eine Orientierung aufweist, die gleich einem Phasenwert ist, der mit der zuvor geschätzten Musterwiederholungsperiode des Signals aus einer Ankunftszeit der Teilmenge berechnet wird, wobei die Vektorsummierung einen resultierenden Vektor liefert.

**5.** Verfahren nach Anspruch 4, bei dem der dem geschätzten Moment zugeordnete Phasenwert gleich dem Argument des resultierenden Vektors ist.

**6.** Verfahren nach Anspruch 3, wobei, wenn die Impulsfolge eine Mehrzahl von aufeinanderfolgenden Impulszügen umfasst, wobei jeder Impulszug einen zugehörigen Phasenmoment aufweist, die genaue Schätzung (70) der einem behandelten Moment zugeordneten Phase außerdem eine Schätzung einer dem Moment entsprechenden Musterwiederholungsperiode aus der Teilmenge der betrachteten Ankunftsdaten umfasst.

**7.** Verfahren nach einem der Ansprüche 1 bis 6, bei dem die Schätzung (20) der Musterwiederholungsperiode des Signals eine erste grobe Schätzung (22) eines ersten Schätzwertes der Musterwiederholungsperiode und eine zweite verfeinerte Schätzung (24) eines zweiten Schätzwertes der Musterwiederholungsperiode umfasst.

**8.** Verfahren nach einem der Ansprüche 1 bis 7, bei dem während des Schritts des Gewinnens (30) einer Folge von Phasen für jedes Impulsankunftsdatum $t_n$ eine Faltung der Periode gleich der geschätzten Musterwiederholungsperiode gemäß der folgenden Formel angewandt wird:

$$\phi(t_n)_{\lambda,t_0} = \lambda \cdot \left( \frac{t_n - t_0}{\lambda} - \left\lfloor \frac{t_n - t_0}{\lambda} \right\rfloor \right)$$

wobei $\lfloor x \rfloor$ der untere ganzzahlige Teil der reellen Zahl x ist, to das Referenzankunftsdatum und $\lambda$ die geschätzte Musterwiederholungsperiode ist.

**9.** Vorrichtung (100) zur Verarbeitung eines durch eine Impulsfolge gebildeten Signals, die mindestens ein durch mindestens einen Impuls gebildetes, sich wiederholendes Muster aufweist, wobei das Muster in dem Signal mit einer Musterwiederholungsperiode wiederholt wird, **dadurch gekennzeichnet, dass** sie mindestens einen Rechenprozessor (110) aufweist, der geeignet ist, zu implementieren:

- eine Einheit zum Schätzen der Musterwiederholungsperiode des Signals,
- eine Einheit zum Berechnen einer Phasenfolge abhängig von einem Ankunftsdatum jedes Impulses in Bezug zu einem ausgewählten Referenzankunftsdatum und der geschätzten Musterwiederholungsperiode,
- eine Einheit zum Schätzen von mindestens einem Phasenwert und einer zugehörigen Standardabweichung aus der Folge von berechneten Phasen, wobei der Phasenwert einem für das sich wiederholende Muster repräsentativen Phasenmoment zugeordnet ist;
- eine Einheit zum Gewinnen und Auswerten von Parametern zur Charakterisierung des digitalen Signals unter Verwendung der geschätzten Phasenwerte.

**10.** Vorrichtung nach Anspruch 9, die außerdem eine Einheit zum Konstruieren eines Phasenhistogramms und zum Extrahieren einer oder mehrerer Spitzen aus dem Histogramm, wobei jede Spitze einem Phasenmoment der Impulsfolge zugeordnet ist, umfasst.

**11.** Computerprogramm, das Softwarebefehle aufweist, die, wenn sie von einer programmierbaren Vorrichtung (100) ausgeführt werden, ein Verfahren zur Verarbeitung eines aus einer Impulsfolge gebildeten Signals nach einem der Ansprüche 1 bis 8 durchführen.

**Claims**

**1.** A method for processing a signal formed from a sequence of pulses, including at least one repeating pattern formed from at least one pulse, said pattern being repeated in the signal with a pattern repetition period, **characterized in that** it includes the following steps:

- estimating (20) the pattern repetition period of said signal,

- calculating (30) a sequence of phases as a function of an arrival date of each pulse relative to a chosen reference arrival date and the estimated pattern repetition period,
- from said calculated sequence of phases, estimating (60, 70) at least one phase value and an associated standard deviation, said phase value being associated with a phase moment representative of the repetitive pattern;
- obtaining (80) and exploiting (90) characterization parameters of the signal by using the estimated phase values.

2. The method according to claim 1, comprising, after the step for calculating (30) a sequence of phases, a step for building (40) a histogram (H) of phases, and extracting (50) one or several peak(s) from the histogram (H), each peak being associated with a phase moment of the sequence of pulses.

3. The method according to claim 2, wherein the step for estimating a phase associated with a moment of the sequence of pulses, said moment being associated with a peak of the phase histogram (H), comprises extracting (60) a subset of arrival dates around said peak, and obtaining (70) a precise estimate of the phase value associated with said moment and a variance associated with the estimated phase value.

4. The method according to claim 3, wherein, when the pulse sequence comprises a plurality of interleaved pulse trains, each pulse train having an associated phase moment, the precise estimation (70) of the phase associated with the moment comprises a vectorial summation of unit vectors, each vector having an orientation equal to a calculated phase value, with the pattern repetition period of said signal estimated beforehand, from an arrival date of said subset, said vectorial summation providing a resulting vector.

5. The method according to claim 4, wherein the phase value associated with said estimated moment is equal to the argument of said resulting vector.

6. The method according to claim 3, wherein, when the sequence of pulses comprises a plurality of successive pulse trains, each pulse train having an associated phase moment, the precise estimation (70) of the phase associated with a treated moment further comprises an estimation of a pattern repetition period corresponding to said moment from a subset of considered arrival dates.

7. The method according to any one of claims 1 to 6, wherein the estimation (20) of the pattern repetition period of the signal includes a first rough estimation (22) of a first estimated value of the pattern repetition period, and a second refined estimation (24) of the second estimated value of the pattern repetition period.

8. The method according to any one of claims 1 to 7, wherein during the step for obtaining (30) a sequence of phases, for each pulse arrival date $t_n$, a period folding equal to the estimated pattern repetition period is applied according to the following formula:

$$\phi(t_n)_{\lambda,t_0} = \lambda \cdot \left( \frac{t_n - t_0}{\lambda} - \left\lfloor \frac{t_n - t_0}{\lambda} \right\rfloor \right)$$

Where $\lfloor x \rfloor$ is the entire bottom part of the real number x, $t_0$ is the reference arrival date and $\lambda$ is the estimated pattern repetition period.

9. A device (100) for processing a signal formed from a sequence of pulses, including at least one repeating pattern formed from at least one pulse, said pattern being repeated in the signal with a pattern repetition period, **characterized in that** it includes at least one computing processor (110) able to implement:

- a unit for estimating the pattern repetition period of said signal,
- a unit for computing a sequence of phases, as a function of an arrival date of each pulse relative to a chosen reference arrival date and the estimated pattern repetition period,
- a unit for estimating, from said calculated sequence of phases, at least one phase value and an associated standard deviation, said phase value being associated with a phase moment representative of the repetitive pattern;
- a unit for obtaining and exploiting characterization parameters of the digital signal by using the estimated phase values.

10. The device according to claim 9, further comprising a unit for building a histogram of phases, and extracting one or several peak(s) from the histogram, each peak being associated with a phase moment of the sequence of pulses.

11. Computer program comprising software instructions which, when they are executed by a programmable device (100), implement a method for processing a signal formed from a sequence of pulses according to claims 1 to 8.

FIG.1

FIG.2

PRM

Per_1

t

Per_2

t

Per_3

t

Per_4

t

FIG.3

H

t

$M_8$

100

160

-130-

-140-

-150-

-120-

-110-

FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2309289 A1

- US 5396250 A

**Littérature non-brevet citée dans la description**

- **DE H. K. MARDIA et al.** New techniques for the deinterleaving of repetitive sequences. *IEE Proceedings F,* Août 1989, vol. 136 (4), 149-154